Europäisches Patentamt

(19) European Patent Office

Office européen des brevets

(11) Numéro de publication: **0 021 915**
**B1**

(12) **FASCICULE DE BREVET EUROPEEN**

(45) Date de publication du fascicule du brevet:
14.03.84

(21) Numéro de dépôt: **80400798.7**

(22) Date de dépôt: **04.06.80**

(51) Int. Cl.³: **H 03 K 4/72,** H 03 K 4/83

(54) Circuit de commande de balayage trame en mode commuté pour récepteur vidéofréquence.

(30) Priorite: **07.06.79 FR 7914590**

(43) Date de publication de la demande:
**07.01.81 Bulletin 81/1**

(45) Mention de la délivrance du brevet:
**14.03.84 Bulletin 84/11**

(84) Etats contractants désignés:
**DE GB SE**

(56) Documents cités:
**EP - A - 0 008 263**
**FR - A - 2 262 442**
**FR - A - 2 371 101**

(73) Titulaire: **THOMSON-BRANDT, 173, Boulevard Haussmann, F-75379 Paris Cedex 08 (FR)**

(72) Inventeur: **Rilly, Gérard, "THOMSON-CSF"SCPI F-173, bld Haussmann, F-75360 PARIS CEDEX 08 (FR)**

(74) Mandataire: **Thrierr, Françoise et al, THOMSON-CSF SCPI 173, Bld Haussmann, F-75379 Paris Cedex 08 (FR)**

BUNDESDRUCKEREI BERLIN

## Circuit de commande de balayage trame en mode commuté pour récepteur vidéofréquence

L'invention concerne un circuit de commande de balayage trame en mode commuté, utilisé notamment dans les récepteurs de télévision.

Le déplacement vertical du spot sur l'écran d'un tube cathodique est essuré par des bobines, dites bobines de déviation verticale, ou de balayage trame, parcourues par un courant généralement en forme de dents de scie. Dans le cas du standard français, ce courant possède une période de 20 ms et une durée de retour de balayage trame inférieure à 1 ms.

Selon l'art antérieur, ce courant est généré à l'aide de dispositifs électroniques composés généralement d'un oscillateur bloqué fournissant une tension en dents de scie synchronisée sur la fréquence trame, d'un étage de liaison à haute impédance d'entrée et faible impédance de sortie, et d'un étage de sortie fournissant aux bobines de déviation verticale le courant d'amplitude et de forme nécessaires à la déviation verticale du spot du tube cathodique. Cet étage de sortie peut être un amplificateur de puissance polarisé en classe A, ou encore un amplificateur à symétrie complémentaire ou »push-pull« polarisé en classe AB.

Des dispositifs à découpage, munie de deux interrupteurs actifs tels que des thyristors, sont aussi utilisés pour générer le courant de balayage trame.

Dans ce cas, l'un des deux interrupteurs actifs assure le balayage vertical de la moitié supérieure de l'écran, en chargeant un condensateur connecté en parallèle avec l'enroulement de déviation verticale par des impulsions de tension de durées décroissantes dans le temps et de polarité donnée.

Le second interrupteur assure le balayage vertical de la moitié inférieure de l'écran, en chargeant le condensateur par des impulsions de tension de durées décroissantes dans le temps et de polarité opposée à la précédente.

La décharge de ce condensateur provoque en effet, l'écoulement d'un courant en dents de scie à travers l'enroulement de déviation verticale.

Les deux voies de ces dispositifs à découpage sont monodirectionnelles en courant chacune dans un sens différent.

Le brevet eurpéen N° 8263, qui appartient à l'état de la technique visé à c'Article 54 (3), au nom de la demanderesse propose un dispositif à découpage à une seule voie, c'est-à-dire un seul interrupteur actif ou commutateur, à élément semiconducteur actif ayant une électrode de commande et à élément redresseur monté en parallèle, et en sens inverse, sur l'élément semiconducteur.

Pour ce faire le déviateur vertical est connecté en série avec une résistance de mesure et un condensateur de liaison dont la valeur est suffisamment élevée pour que la tension aux bornes de l'ensemble ainsi formé garde une même polarité quel que soit le sens du courant traversant le déviateur vertical. Cet ensemble se comporte alors tantôt en générateur, tantôt en récepteur, et est connecté à un circuit générateur d'un signal en dents de scie à partir du signal de retour de balayage ligne commandé par un circuit de commande synchronisé à la fréquence de ligne.

Conformément au brevet européen N° 8263 précédemment cité, l'interrupteur actif ou commutateur est mis en conduction durant l'aller de balayage ligne, l'instant de début de sa conduction définissant le courant traversant le déviateur.

Afin d'obtenir, pour un tel dispositif à découpage à une seule voie, une amplitude et une linéarité de l'image stables malgré les défauts de dérive et de non-linéarité des composants électroniques, le brevet européen N° 8263 a proposé un système d'asservissement.

A cet effet le brevet antérieur comporte, pour commander ledit commutateur ou interrupteur actif un circuit de commande de rapport cyclique pour qu'à chaque période de balayage-ligne ce commutateur soit conducteur pendant un temps qui est fonction du niveau souhaité pour le courant dans la déviateur vertical et ce circuit de commande de rapport cyclique est relié, d'une part, à un circuit d'asservissement statique permettant de stabiliser la valeur moyenne de la tension aux bornes du condensateur de liaison, en série avec le déviateur vertical, et, d'autre part, à un circuit d'asservissement dynamique pour asservir le courant dans le déviateur au signal fourni par un générateur de dents de scie trame corrigées.

La présente invention permet de perfectionner l'objet du brevet européen N° 8263. Elle fournit un système d'asservissement simple et efficace.

Selon l'invention le circuit de commande de rapport cyclique comporte un transistor en commutation recevant sur sa base, d'une part, un signal en dents de scie ligne de synchronisation et, d'autre part, les signaux de correction provenant des circuits d'asservissement statique et dynamique, son collecteur étant connecté à l'électrode de commande de l'interrupteur actif.

D'autres caractéristiques et avantages de l'invention ressortiront de la description suivante, donnée à titre d'exemple non limitatif et illustrée par les figures annexées qui représentent:

— la figure 1, un shéma synoptique d'un circuit de balayage trame en mode commuté comportant un circuit de commande selon l'invention;

— la figure 2, un schéma d'un exemple de réalisation du circuit de commande de balayage trame en mode commuté selon l'invention;

— les figures 3a, b, c, des représentations graphiques de différentes tensions mesurées sur le circuit représenté à la figure 2.

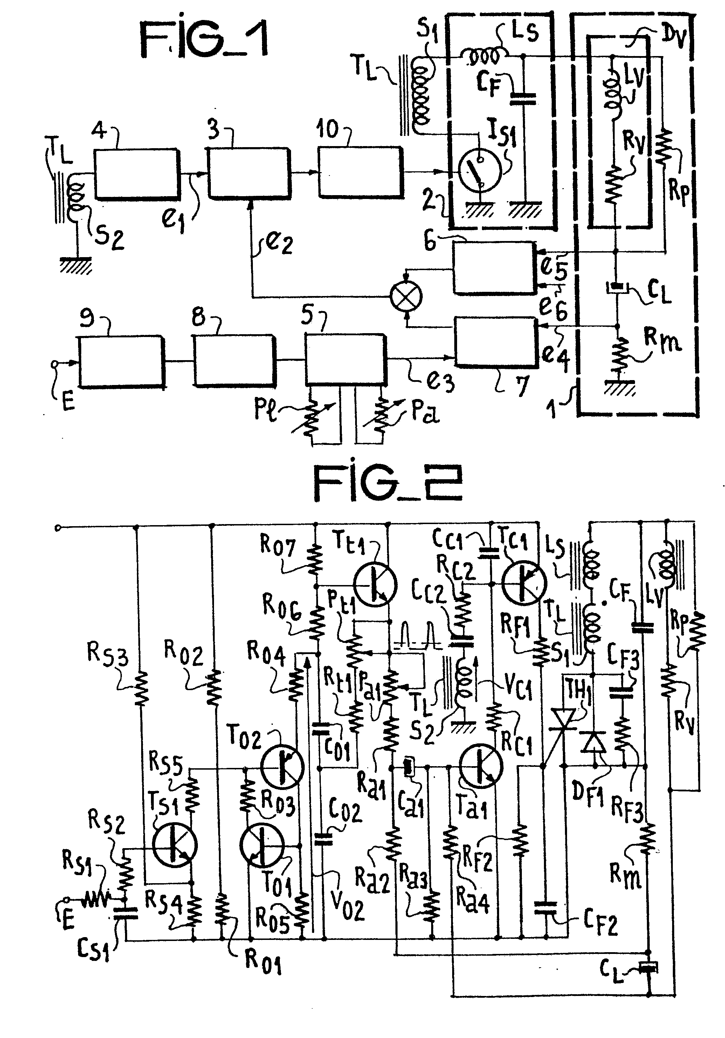

La figure 1 représente un schéma synoptique d'un circuit de balayage trame en mode commuté.

La charge 1 comporte le déviateur vertical $D_v$ protégé par une résistance parallèle $R_p$, un condensateur de liaison $C_L$ et une résistance de mesure $R_m$.

La valeur du condensateur $C_L$ est choisie de manière à avoir à ses bornes une tension suffisamment élevée, telle que décrit dans le brevet européen N° 8263 précédemment cité, pour obtenir aux bornes de la charge une tension positive quel que soit le sens du courant dans le déviateur. La charge se comporte donc dans un premier temps en récepteur d'énergie et dans un second temps en générateur.

Cette charge 1 est connectée aux bornes d'un circuit générateur 2 d'un signal en dents de scie.

Ce circuit 2 génère dans le déviateur vertical $D_v$ un signal en dents de scie à partir des signaux de retour de balayage ligne.

En effet, lors du retour de balayage ligne, il apparaît dans les enroulements secondaires du transformateur ligne, un signal alternatif périodique à la fréquence ligne.

Le courant en dents de scie est obtenu par un découpage de ce signal alternatif engendré dans un enroulement secondaire du transformateur ligne $T_L$. Ce découpage est effectué à l'aide d'un interrupteur actif $I_{S1}$ ou commutateur, à élément semi conducteur actif ayant une électrode de commande et à élément redresseur monté en parallèle, et en sens inverse, sur l'élément actif, connecté en série avec l'enroulement secondaire $S_1$ du transformateur $T_L$, ainsi qu'avec l'inductance $L_s$ non couplée au transformateur ligne, l'ensemble étant monté en parallèle avec un condensateur de filtrage $C_f$.

La valeur du condensateur $C_f$ est choisie suffisamment grande pour que la partie alternative de la tension aux bornes soit très faible devant le signal aux bornes de l'enroulement $S_1$ et donc négligeable.

Un autre enroulement secondaire $S_2$ du transformateur ligne est connecté en entrée d'un circuit générateur de dents de scie ligne 4. Ce circuit 4 fournit à partir d'un signal disponible aux bornes de l'enroulement $S_2$, un signal en dents de scie durant l'aller de balayage ligne.

Ce signal en dents de scie est injecté en une entrée $e_1$ d'un circuit de commande de rapport cyclique 3, qui délivre un signal rectangulaire en entrée d'un circuit d'interface 10 dont la sortie est connectée à l'électrode commande de l'interrupteur actif $I_{S1}$.

Ce circuit interface permet d'adapter le signal de commande rectangulaire disponible en sortie du circuit de commande 3 de rapport cyclique, en fonction des caractéristiques électriques de l'interrupteur actif $I_{S1}$.

Le front avant du signal rectangulaire correspond à l'instant de fermeture de l'interrupteur actif $I_{S1}$.

Or, la position de ce front avant, et donc l'instant de fermeture de l'interrupteur actif $I_{S1}$, dépendent du signal appliqué en entrée $e_2$ du circuit de commande de rapport cyclique.

Comme il a été décrit dans le brevet européen N° 8263, plus l'interrupteur actif $I_{S1}$ est déclenché à un instant en avance sur l'instant de début de retour ligne, et plus le courant moyen dans l'inductance $L_s$ décroît par rapport à sa valeur maximum correspondant au cas où l'interrupteur actif est toujours bloqué.

Il est donc possible de contrôler la valeur du courant moyen dans l'inductance $L_s$, donc la valeur du courant dans le déviateur $D_v$ en contrôlant l'instant de fermeture de l'interrupteur actif $I_{S1}$. Pendant l'aller de balayage trame, pour que le courant dans le déviateur vertical $D_v$ suive une loi en dents de scie trame, il suffit donc de commander convenablement les instants successifs de fermeture de l'interrupteur actif $I_{S1}$.

Cette commande convenable va être assurée par le signal appliqué en entrée $e_2$ du circuit de commande de rapport cyclique 3.

Ce signal provient d'une part d'un circuit d'asservissement dynamique 7 dont l'entrée $e_4$ est connectée aux bornes de la résistance de mesure $R_m$, et l'entrée $e_3$ à un circuit générateur de dents de scie corrigées 5.

La tension aux bornes de $R_m$ est fonction du courant traversant le déviateur vertical $D_v$. Le circuit d'asservissement 7 fournit donc un signal d'erreur fonction de la différence entre le courant de déviation verticale et la tension en dents de scie corrigées.

Un circuit séparateur trame 9 reçoit en entrée E les signaux de synchronisation complets prélevés sur le signal vidéo, et après intégration et écrêtage délivre un signal de synchronisation trame.

Ce signal de synchronisation trame est appliqué en entrée d'un circuit oscillateur 8. Ce dernier pilote le circuit générateur de dents de scie corrigées dont la forme préfigure le courant nécessaire dans la bobine de déviateur verticale $D_v$. On dispose en général à ce niveau d'un réglage de linéarité et d'amplitude, symbolisé par les potentiomètres $P_L$ et $P_a$.

L'entrée $e_2$ du circuit de commande de rapport cyclique 3 est d'autre part connectée à un circuit d'asservissement statique 6 qui assure le maintien et la surveillance de la tension moyenne aux bornes du condensateur de liaison $C_L$ par rapport à une consigne définie en vue d'assurer un fonctionnement correct et optimum du circuit de balayage trame en mode commuté.

La figure 2 représente un exemple de réalisation simple d'un circuit de commande de balayage trame selon l'invention.

Les signaux de synchronisation complets prélevés sur le signal vidéo sont appliqués en entrée E.

Le circuit séparateur trame est constitué d'une part d'un étage intégrateur $R_{S1}$, $C_{S1}$ et $R_{S2}$ montés en T, et d'autre part d'un transistor $T_{S1}$ polarisé par les résistances $R_{S3}$ et $R_{S4}$.

L'entrée E se fait sur une borne de la résistance $R_{S1}$, et la base du transistor $T_{S1}$ est connectée à une borne de la résistance $R_{S2}$.

Les résistances $R_{S3}$ et $R_{S4}$ provoquent une polarisation d'émetteur créant le seuil de déclenchement du transistor $T_{S1}$.

Lorsque le signal de synchronisation appliqué en entrée E caractérise le top de synchronisation trame, le transistor $T_{S1}$ passe d'un état bloqué à un état saturé.

Le collecteur du transistor $T_{S1}$ est connecté au travers d'une résistance $R_{S5}$ en entrée d'un circuit oscillateur.

Ce circuit oscillateur comporte deux transistors $T_{O1}$ et $T_{O2}$ fonctionnant simultanément dans les étants bloqués ou saturés.

Lorsque ces deux transistors $T_{O1}$ et $T_{O2}$ sont saturés (retour trame), la tension collecteur-émetteur étant quasiment nulle, la tension $V_{O1}$ aux bornes de la résistance $R_{O1}$ est faible. Le courant traversant alors les résistances $R_{O7}$, $R_{O6}$, $R_{O4}$ connectées dans le circuit émetteur du transistor $T_{O2}$, doit être alors insuffisant pour maintenir l'état saturé des deux transistors $T_{O1}$, $T_{O2}$. De cette manière lorsque les condensateurs $C_{O1}$ et $C_{O2}$ sont suffisamment déchargés, les transisitors $T_{O1}$ et $T_{O2}$ se bloquent. La tension $V_{O1}$ passe donc brutalement d'une valeur faible à une valeur plus importante, cette valeur étant imposée par le pont diviseur constitué par les résistances $R_{O1}$ et $R_{O2}$.

Les résistances $R_{O7}$ et $R_{O6}$ assurent la charge des condensateurs $C_{O1}$ et $C_{O2}$ jusqu'au moment où le transistor $T_{O2}$ redevient saturé.

La fréquence de l'oscillateur ainsi obtenu, si l'on déconnecte la résistance $R_{S5}$, est légèrement inférieure à la fréquence trame c'est-à-dire 50 Hz.

Au moment du top de synchronisation trame, le transistor $T_{S1}$ devenant saturé, les transistors $T_{O1}$ et $T_{O2}$ étant bloqués, la tension $V_{O1}$ baisse pour pendre une valeur fonction de la résistance $R_{S5}$. Pour que les transistors $T_{O1}$ et $T_{O2}$ passent en état saturé, il faut qu'à ce même instant la tension $V_{O2}$ aux bornes des condensateurs séries $C_{O1}$ et $C_{O2}$ devienne supérieure à la tension $V_{O1}$ aux bornes de la résistance $R_{O1}$.

L'impulsion de saturation délivrée par le collecteur du transistor $T_{S1}$ ne sera prise en compte que pendant une certaine partie de la période de l'oscillateur correspondant à la fin de charge des condensateurs $C_{O1}$ et $C_{O2}$, c'est-à-dire lorsque la tension de charge sera supérieure à la tension $V_{O1}$.

Ceci permet d'améliorer en partie l'immunité de l'oscillateur face aux impulsions parasites provoquant la saturation du transistor $T_{S1}$.

Ce circuit oscillateur est connecté à un circuit tampon comportant le transistor $T_{t1}$, la résistance $R_{t1}$ et le potentiomètre $P_{t1}$.

La tension $V_{O2}$ aux bornes des condensateurs $C_{O1}$ et $C_{O2}$ varie suivant une loi proche d'une dent de scie.

La résistance $R_{O7}$ étant très grande, le transistor $T_{t1}$ dont la base est connectée au point de jonction des deux résistances $R_{O7}$ et $R_{O6}$, constitue un étage abaisseur d'impédance, de manière à connecter entre l'émetteur du transistor $T_{t1}$ et le point commun de connexion des condensateurs $C_{O1}$ et $C_{O2}$, le réseau composé d'une résistance $R_{t1}$ en série avec un potentiomètre $P_{t1}$.

On ajoute ainsi à la tension en dents de scie disponible aux bornes des condensateurs séries $C_{O1}$ et $C_{O2}$, une tension parabolique due à $P_{t1}$, $R_{t1}$ et au condensateur $C_{O2}$.

On obtient ainsi en $V_{t2}$ entre l'émetteur du transistor $T_{t1}$ et la masse, une tension en dents de scie corrigées en S correspondant à la loi du courant nécessaire dans le déviateur trame $D_v$.

On obtient donc en sortie $V_{t1}$ le signal en dents de scie corrigées nécessaire au circuit d'asservissement dynamique selon l'invention qui sera décrit plus loin.

Le circuit de commande de rapport cyclique selon l'invention ne comporte qu'un seul étage actif, le transistor $T_{c1}$ polarisé en commutation.

Ce transistor $T_{c1}$ a sa base connectée à un circuit générateur de dents de scie ligne à partir du signal de retour ligne.

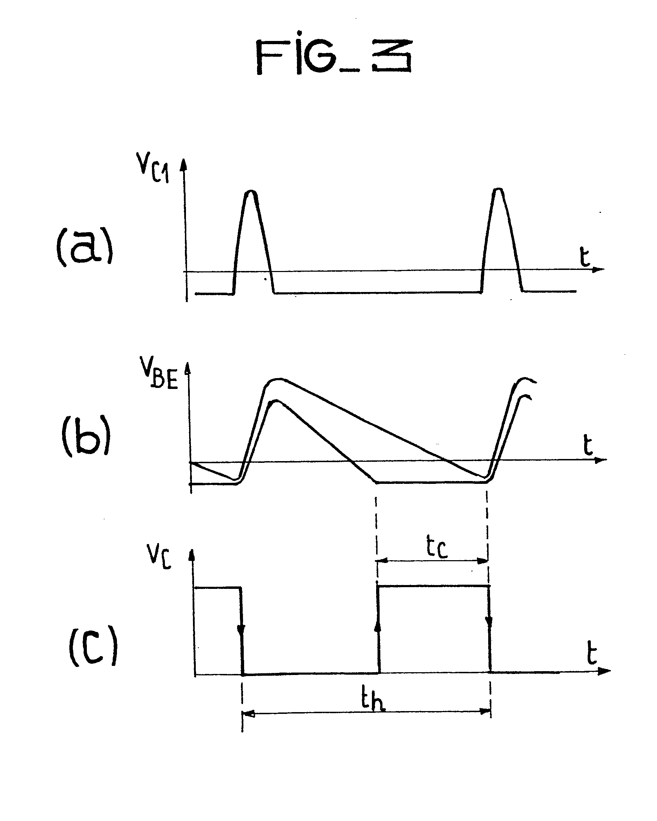

En effet, le circuit formé par le condensateur $C_{c2}$ en série avec la résistance $R_{c2}$, et le condensateur $C_{c1}$ constitue un intégrateur transformant la tension de retour de balayage ligne $V_{c1}$, représentée à la figure 3a, prélevée sur l'enroulement $S_2$ du transformateur ligne $T_L$, en un signal triangulaire.

Ce signal triangulaire disponible entre la base et l'émetteur du transistor $T_{c1}$ est visualisé à la figure 3b.

Le collecteur du transistor $T_{c1}$ est connecté au travers d'un circuit interface d'adaptation ($R_{f1}$, $R_{f2}$, $C_{f2}$) à la gachette d'un thyristor $TH_1$ constituant avec la diode $D_{f1}$ et la résistance $R_{f3}$ en série avec le condensateur $C_{f3}$, l'interrupteur actif $I_{S1}$.

En effet, conformément à la figure 1, le déviateur vertical constitué de l'inductance $L_v$ et de la résistance série $R_v$, protégé par la résistance $R_p$ est connecté en série avec le condensateur de liaison $C_L$ et la résistance de mesure $R_m$.

La charge ainsi constituée est connectée en parallèle avec le générateur de signal en dents de scie comportant le condensateur $C_f$ connecté en parallèle avec l'ensemble constitué de l'inductance $L_S$ en série avec l'enroulement $S_1$ du transformateur ligne $T_L$ et l'interrupteur actif $TH_1$, $D_{f1}$, $C_{f3}$, et $R_{f3}$.

La cathode de la diode $D_{f1}$ est connectée à l'anode du thyristor $TH_1$ et à une borne de l'enroulement $S_1$. L'anode de cette diode $D_{f1}$ est connectée à la cathode du thyristor et à une borne du condensateur $C_f$.

Ce thyristor $TH_1$ fonctionne en interrupteur; lorsque son courant gachette est suffisant pour qu'il soit passant, il court-circuite la diode $D_{f1}$.

La forme du courant dans le déviateur vertical est liée à l'instant de fermeture de cet interrupteur actif comme décrit dans le brevet européen N° 8263 déposé au nom de la demanderesse.

Le circuit d'asservissement dynamique est constitué par la résistance $R_{a2}$ dont une borne est connectée à la résistance $R_m$ et l'autre à la résistance $R_{a1}$ en série avec le potentiomètre $P_{a1}$, le condensateur $C_{a1}$ et le transistor $T_{a1}$.

Le potentiomètre $P_{a1}$ reçoit sur une de ses bornes le signal en dents de scie corrigées disponible sur l'émetteur de $T_{t1}$.

L'émetteur du transistor $T_{a1}$ est connecté à la masse, et son collecteur à la base du transistor $T_{c1}$ au travers d'une résistance $R_{c1}$.

Le sens du courant dans le déviateur trame est tel que, pendant l'aller du balayage trame, la tension aux bornes de la résistance de mesure $R_m$ est en opposition de phase avec la tension en dents de scie corrigée $V_{t1}$. La tension en dents de scie corrigées est donc comparée à la tension aux bornes de la résistance de mesure $R_m$ par le pont de résistance $R_{a2}, R_{a1}, P_{a1}$.

Le transistor $T_{a1}$ amplifie le signal d'erreur dynamique éventuel entre la tension aux bornes de la résistance $R_m$ et la tension en dents de scie corrigées.

La tension aux bornes de $R_m$ étant fonction du courant traversant le déviateur vertical, le signal d'erreur est donc fonction de la différence entre le courant de déviation verticale et la tension en dents de scie corrigées.

Ce signal d'erreur se retrouve donc dans le circuit collecteur du transistor $T_{a1}$.

De plus, l'asservissement statique est obtenu par les résistances $R_{a4}, R_{a3}$ et le même transistor $T_{a1}$.

La tension de référence est le seuil de tension de base du transistor $T_{a1}$ fixé par la résistance $R_{a3}$.

La base du transistor $T_{a1}$ est connectée au travers d'une résistance $R_{a4}$ à la borne positive du condensateur électrochimique $C_L$. Si la tension moyenne aux bornes de condensateur $C_L$ tend à croître, le courant base du transistor $T_{a1}$ croît, et donc son courant collecteur aussi.

Cet accroissement du courant collecteur provoque un accroissement de la durée en état saturé du transistor $T_{c1}$ du circuit de commande de rapport cyclique et une avance de l'amorçage du thyristor $TH_1$ entraînant par là-même une réduction de la tension moyenne du condensateur $C_L$.

En effet, en absence de courant collecteur du transistor $T_{a1}$, les condensateurs $C_{c1}$ et $C_{c2}$ prennent une charge moyenne suffisante pour garder le transistor $T_{c1}$ bloqué. Et lorsqu'un courant continu apparaît dans le circuit collecteur du transistor $T_{a1}$, la combinaison de ce courant avec celui dû au circuit générateur de dents de scie ligne ($C_{c2}, R_{c2}, C_{c1}$) entraîne la mise en saturation du transistor $T_{c1}$ durant la fin de l'aller du balayage ligne.

On obtient alors en collecteur du transistor $T_{c1}$, un signal en créneaux comme représenté à la figure 3c.

La durée de conduction du transistor $T_{c1}$, c'est-à-dire le temps $T_c$ de la figure 3c dépend du courant collecteur du transistor $T_{a1}$, lequel modifie la forme de la tension de commande base-émetteur du transistor $T_{c1}$ tel que représenté en figure 3b.

Le début de fermeture de $TH_1$ correspond au front avant du signal en créneaux disponible en sortie collecteur du transistor $T_{c1}$.

D'autre part, la résistance $R_{c1}$ a pour rôle de limiter le courant collecteur du transistor $T_{a1}$ et le courant base du transistor $T_{c1}$ lorsque le transistor $T_{a1}$ tend à se saturer en cas de phénomènes accidentels.

Le gain du transistor est choisi tel que, pendant l'aller de balayage trame, la variation de la tension de base de $T_{a1}$ est négligeable devant la tension alternative en dents de scie corrigées et la tension aux bornes de la résistance $R_m$. Le courant alternatif traversant le condensateur $C_{a1}$ est donc faible devant le courant traversant le pont de résistances $P_{a1} + R_{a1}, R_{a2}$. La loi de variation de la tension aux bornes de la résistance $R_m$ est donc la même que celle en dents de scie corrigées au près puisqu'elles sont en opposition de phase.

L'asservissement dynamique ainsi réalisé est tel que le courant parcourant le déviateur est l'image de la tension en dents de scie corrigées.

Et d'autre part, le bon fonctionnement de l'étage de sortie en commutation est assuré par l'asservissment statique décrit précédemment.

Ce circuit de commande de balayage trame à un seul interrupteur actif présente donc l'avantage d'avoir un circuit de commande de rapport cyclique simplifié et asservi.

Ce circuit de commande pour balayage trame en mode commuté selon l'invention est principalement utilisé dans les récepteurs de télévision transistorisés.

## Revendications

1. Circuit de balayage trame dans lequel: l'énrgie nécessaire pour engendrer le courant dans le déviateur vertical ($D_v$) est tirée des impulsions de retour ligne grâce à des moyens de filtrage et à un unique commutateur ($I_{S1}$) à élément semi-conducteur actif ($TH_1$) ayant une électrode de commande et à élément redresseur ($D_{f1}$) monté en parallèle, et en sens inverse, sur l'élément semiconducteur, le commutateur étant commandé par un circuit de commande de rapport cyclique (3) pour qu'à chaque période de balayage ligne il soit conducteur pendant un temps qui est fonction du niveau souhaité pour le courant dans le déviateur vertical; un condensateur de liaison ($C_L$) est en série avec le déviateur vertical et a une capacité de valeur suffisamment élevée pour que la tension aux bornes de l'ensemble en série comprenant le déviateur et ce condensateur garde un signe constant; ledit circuit de commande de rapport cyclique (3) est relié, d'une part, à un circuit d'asservissement statique (6) permettant de stabiliser la valeur moyenne de la tension aux bornes du condensateur ($C_L$) et, d'autre part, à un circuit d'asservissement dynamique (7) pour asservir le courant

dans le déviateur ($D_v$) au signal fourni par un générateur (5) de dents de scie trame corrigées; ledit circuit de commande de rapport cyclique (3) comporte un transistor en commutation ($T_{c1}$) recevant sur sa base, d'une part, un signal en dents de scie ligne de synchronisation et, d'autre part, les signaux de correction provenant des circuits d'asservissement statique (6) et dynamique (7), son collecteur étant connecté à l'électrode de commande du commutateur ($I_{S1}$).

2. Circuit selon la revendication 1, caractérisé en ce que le commutateur ($I_{S1}$) comporte un thyristor ($TH_1$) dont l'anode est connectée à la cathode d'une diode ($D_{f1}$) et la cathode à l'anode de cette même diode ($D_{f1}$), la gachette de ce thyristor étant connectée, au travers d'un circuit interface (10) de mise en forme, au collecteur du transistor ($T_{c1}$) du circuit de commande de rapport cyclique (3).

3. Circuit selon la revendication 2, caractérisé en ce que le circuit interface (10) de mise en forme comporte une résistance ($R_{f1}$) dont une borne est connectée au collecteur du transistor ($T_{c1}$) du circuit de commande de rapport cyclique (3) et l'autre est connectée d'une part à une borne d'un réseau comportant une résistance ($R_{f2}$) en parallèle avec un condensateur ($C_{f2}$) dont l'autre borne est à la masse, et d'autre part à la gachette du thyristor ($TH_1$).

4. Circuit selon l'une des revendications 1 à 3, caractérisé en ce que le circuit d'asservissement statique (6) comporte un transistor d'asservissement ($T_{a1}$) recevant sur sa base d'une part un signal d'erreur provenant de la différence entre une tension de référence et la tension aux bornes du condensateur de liaison ($C_L$) et d'autre part, le signal d'erreur du circuit d'asservissement dynamique (7) comportant deux résistances en série ($P_{a1} + R_{a1}$, $R_{a2}$), une ($P_{a1} + R_{a1}$) de ces résistances étant connectée au circuit générateur de dents de scie trame corrigées (5), l'autre ($R_{a2}$) à une résistance de mesure ($R_m$) en série avec le déviateur, et leur point commun de connexion au travers d'un condensateur ($C_{a1}$) à la base du transistor d'asservissement ($T_{a1}$) dont le collecteur est connecté en entrée ($e_2$) du circuit de commande de rapport cyclique (3).

5. Circuit selon la revendication 4, caractérisé en ce que la tension de référence du circuit d'asservissement statique (6) est fixée par une résistance ($R_{a3}$) connectée entre la base du transistor d'asservissement ($T_{a1}$) et la masse.

6. Circuit de commande de balayage trame selon la revendication 4 ou 5, caractérisé en ce que le circuit collecteur du transistor d'asservissement ($T_{a1}$) comporte une résistance de protection ($R_{c1}$) contre les variations trop importantes du courant collecteur de ce transistor d'asservissement.

7. Récepteur vidéofréquence comportant un circuit de balayage trame dans lequel: l'énergie nécessaire pour engendrer le courant dans le déviateur vertical ($D_v$) est tirée des impulsions de retour ligne grâce à des moyens de filtrage et à un unique commutateur ($I_{S1}$) à élément semicon-ducteur actif ($TH_1$) ayant une électrode de commande et à élément redresseur ($D_{f1}$) monté en parallèle, et en sens inverse, sur l'élément semiconducteur, le commutateur étant commandé par un circuit de commande de rapport cyclique (3) pour qu'à chaque période de balayage ligne il soit conducteur pendant un temps qui est fonction du niveau souhaité pour le courant dans le déviateur vertical; un condensateur de liaison ($C_L$) est en série avec le déviateur vertical et a une capacité de valeur suffisamment élevée pour que la tension aux bornes de l'ensemble en série comprenant le déviateur et ce condensateur garde un signe constant; ledit circuit de commande de rapport cyclique (3) est relié, d'une part, à un circuit d'asservissement statique (6) permettant de stabiliser la valeur moyenne de la tension aux bornes du condensateur ($C_L$) et, d'autre part, à un circuit d'asservissement dynamique (7) pour asservir le courant dans le déviateur ($D_v$) au signal fourni par un générateur (5) de dents de scie trame corrigées; ledit circuit de commande de rapport cyclique (3) comporte un transistor en commutation ($T_{c1}$) recevant sur sa base, d'une part, un signal en dents de scie ligne de synchronisation et, d'autre part, les signaux de correction provenant des circuits d'asservissement statique (6) et dynamique (7), son collecteur étant connecté à l'électrode de commande du commutateur ($I_{S1}$).

**Patentansprüche**

1. Bildablenkschaltung, in welcher: die erforderliche Energie für die Erzeugung des Stromes in dem Vertikal-Ablenkelement ($D_v$) aus den Zeilenrücklaufimpulsen durch Filtermittel und durch einen einzigen Schalter ($I_{S1}$) gewonnen wird, der ein aktives Halbleiterelement ($TH_1$) mit einer Steuerelektrode aufweist und dem ein Gleichrichterelement ($D_{f1}$) in entgegengesetztem Sinn zu dem Halbleiterelement parallel geschaltet ist, wobei der Schalter gesteuert wird durch eine Steuerschaltung (3) zur Steuerung des zyklischen Verhältnisses, damit er bei jeder Zeilenablenkperiode während einer Zeitspanne leitend ist, die abhängt von dem gewünschten Pegel für den Strom in dem Vertikal-Ablenkelement; wobei ein Kopplungskondensator ($C_L$) in Reihe mit dem Vertikal-Ablenkelement liegt und eine Kapazität von einem ausreichend hohen Wert aufweist, damit die Spannung an den Anschlüssen der gesamten Serienschaltung, welche das Ablenkelement und diesen Kondensator umfaßt, ein konstantes Vorzeichen bewahrt; wobei die Steuerschaltung (3) zur Steuerung des zyklischen Verhältnisses einerseits mit einer statischen Regelschaltung (6) verbunden ist, welche die Stabilisierung des Mittelwertes der Spannung an den Anschlüssen des Kondensators ($C_L$) ermöglicht, und andererseits mit einer dynamischen Regelschaltung (7) verbunden ist, um den Strom in dem Ablenkelement ($D_v$) durch das Signal zu regeln, das von einem Generator (5) zur Erzeugung von korrigierten sägezahnförmigen Bildsignalen geliefert wird; wobei die Steuerschaltung (3) zur Steuerung des zyklischen Verhältnisses einen Schalttransistor ($T_{c1}$) umfaßt, der an seiner Basis einerseits ein sägezahnförmiges Zeilensynchronisationssignal und andererseits die Korrektursignale empfängt, die aus der statischen (6) und aus der dynamischen (7) Regelschaltung stammen, während sein Kollektor mit der Steuerelektrode des Schalters ($I_{S1}$) verbunden ist.

2. Schaltung nach Anspruch 1, dadurch gekennzeichnet, daß der Schalter ($I_{S1}$) einen Thyristor ($TH_1$) umfaßt, dessen Anode mit der Kathode einer Diode ($D_{f1}$) und dessen Kathode mit der Anode dieser selben Diode ($D_{f1}$) verbunden ist, wobei die Steuerelektrode dieses Thyristors über eine Formgebungs-Schnittstellenschaltung (10) mit dem Kollektor des Transistors ($T_{c1}$) der Steuerschaltung (3) zur Steuerung des zyklischen Verhältnisses verbunden ist.

3. Schaltung nach Anspruch 2, dadurch gekennzeichnet, daß die Formgebungs-Schnittstellenschaltung (10) einen Widerstand ($R_{f1}$) umfaßt, wovon ein Anschluß mit dem Kollektor des Transistors ($T_{c1}$) der Steuerschaltung (3) zur Steuerung des zyklischen Verhältnisses verbunden ist, während der andere einerseits mit einem Anschluß eines Netzwerks verbunden ist, das einen Widerstand ($R_{f2}$) parallel zu einem Kondensator ($C_{f2}$) umfaßt, wovon der andere Anschluß an Masse liegt, und andererseits mit der Steuerelektrode des Thyristors ($TH_1$) verbunden ist.

4. Schaltung nach einem der Ansprüche 1 bis 3, dadurch gekennzeichnet, daß die statische Regelschaltung (6) einen Regeltransistor ($T_{a1}$) umfaßt, der an seiner Basis zum einen ein Fehlersignal empfängt, welches von der Differenz zwischen einer Bezugsspannung und der Spannung an den Anschlüssen des Koppelkondensators ($C_L$) herrührt, und andererseits das Fehlersignal der dynamischen Regelschaltung (7) empfängt, die zwei in Reihe liegende Widerstände ($P_{a1} + R_{a1}$, $R_{a2}$) umfaßt, wobei einer ($P_{a1} + R_{a1}$) dieser Widerstände mit der Schaltung (5) zur Erzeugung von korrigierten sägezahnförmigen Bildsignalen verbunden ist, während der andere ($R_{a2}$) mit einem Meßwiderstand ($R_m$) in Reihe mit dem Ablenkelement verbunden ist, während ihr gemeinsamer Verbindungspunkt über einen Kondensator ($T_{a1}$) mit der Basis des Regeltransistors ($T_{a1}$) verbunden ist, dessen Kollektor an den Eingang ($e_2$) der Steuerschaltung (3) zur Steuerung des zyklischen Verhältnisses angeschlossen ist.

5. Schaltung nach Anspruch 4, dadurch gekennzeichnet, daß die Bezugsspannung der statischen Regelschaltung (6) durch einen Widerstand ($R_{a3}$) festgelegt ist, der zwischen die Basis des Regeltransistors ($T_{a1}$) und Masse geschaltet ist.

6. Bildablenksteuerschaltung nach Anspruch 4 oder 5, dadurch gekennzeichnet, daß der Kollektorkreis des Regeltransistors ($T_{a1}$) einen Schutzwiderstand ($R_{c1}$) zum Schutz gegen zu große Änderungen des Kollektorstroms dieses Regeltransistors enthält.

7. Videofrequenzempfänger, welcher eine Bildablenkschaltung enthält, in welcher: die für die Erzeugung des Stromes in dem Vertikal-Ablenkelement ($D_v$) erforderliche Energie den Zeilenrücklaufimpulsen durch Filtermittel und einen einzigen Schalter ($I_{S1}$) entnommen wird, der ein aktives Halbleiterelement ($TH_1$) mit einer Steuerelektrode und ein Gleichrichterelement ($D_{f1}$) enthält, welches in entgegensetztem Sinne zu dem Halbleiterelement parallel geschaltet ist, wobei der Schalter gesteuert ist durch eine Steuerschaltung (3) zur Steuerung des zyklischen Verhältnisses, damit er bei jeder Zeilenablenkperiode während einer Zeitspanne leitend ist, die abhängig ist von der gewünschten Höhe des Stroms in dem Vertikal-Ablenkelement; wobei ein Koppelkondensator ($C_L$) in Reihe mit dem Vertikal-Ablenkelement liegt und eine Kapazität von ausreichend hohem Wert aufweist, damit die Spannung an den Anschlüssen der gesamten Reihenschaltung, die das Ablenkelement und diesen Kondensator enthält, ein konstantes Vorzeichen bewahrt; wobei die Steuerschaltung (3) zur Steuerung des zyklischen Verhältnisses einerseits verbunden ist mit einer statischen Regelschaltung (6), welche die Stabilisierung des Mittelwertes der Spannung an den Anschlüssen des Kondensators ($C_L$) ermöglicht, und andererseits verbunden ist mit einer dynamischen Regelschaltung (7) zur Regelung des Stromes in dem Ablenkelement ($D_v$) durch das von einem Generator (5) gelieferte sägezahnförmige korrigierte Bildsignal; wobei die Steuerschaltung (3) zur Steuerung des zyklischen Verhältnisses einen Schalttransistor ($T_{c1}$) umfaßt, der an seiner Basis zum einen ein sägezahnförmiges Zeilensynchronisationssignal und zum anderen die Korrektursignale empfängt, die aus der statischen (6) und der dynamischen (7) Regelschaltung stammen, während sein Kollektor mit der Steuerelektrode des Schalters ($I_{S1}$) verbunden ist.

**Claims**

1. Frame scanning circuit in which: the energy necessary for generating the current in the vertical deflector ($D_v$) is taken from the line flyback pulses by way of filter means and a single switch ($I_{S1}$) which comprises an active semiconductor element ($TH_1$) having a control electrode, and a rectifier member ($D_{f1}$) connected in parallel and in reverse sense to the semiconductor element, the switch being controlled by a cyclic ratio control circuit (3) so that for each line scan period it becomes conductive during a time which is a function of the desired level for the current in the vertical deflector; a coupling capacitor ($C_L$) is in series with the vertical deflector and has a capacitance of sufficiently high value for the voltage at the terminals of the series assembly including the deflector and said capacitor to retain a constant sign; said cyclic ratio control circuit (13) is connected on the one hand to a static slaving circuit (6) permitting the stabilization of the mean value of the voltage at the terminals of the capacitor $(C_L)$ and, on the other hand, to a dynamic slaving circuit (7) for slaving the current in the deflector $(D_v)$ by the signal supplied by a corrected sawtooth frame signal generator (5), said cyclic ratio control circuit (3) includes a switching transistor $(T_{c1})$ receiving at its base on the one hand a sawtooth line synchronization signal and on the other hand the correction signals originating from the static (6) and dynamic (7) slaving circuits, its collector being connected to the control electrode of the switch $(I_{S1})$.

2. Circuit according to Claim 1, characterized in that the switch $(I_{S1})$ includes a thyristor $(TH_1)$ of which the anode is connected to the cathode of a diode $(D_{f1})$ and the cathode to the anode of said same diode $(D_{f1})$, the gate of said transistor being connected via a shaping interface circuit (10) to the collector of the transistor $(T_{c1})$ of the cyclic ratio control circuit (3).

3. Circuit according to Claim 2, characterized in that the shaping interface circuit (10) includes a resistor $(R_{f1})$ whose one terminal is connected to the collector of the transistor $(T_{c1})$ of the cyclic ratio control circuit (3) and whose other is connected on the one hand to a terminal of a network including a resistor $(R_{f2})$ in parallel with a capacitor $(C_{f2})$ whose other terminal is connected to ground, and on the other hand to the gate of the thyristor $(TH_1)$.

4. Circuit according to one of Claims 1 to 3, characterized in that the static slaving circuit (6) includes a slaving transistor $(T_{a1})$ which receives at its base on the one hand an error signal originating from the difference between a reference voltage and a voltage at the terminals of the coupling capacitor $(C_L)$ and on the other hand the error signal of the dynamic slaving circuit (7), comprising two resistors in series $(P_{a1} + R_{a1}, R_{a2})$, one $(P_{a1} + R_{a1})$ of said resistors being connected to the circuit (5) for generating corrected sawtooth frame signals, the other $(R_{a2})$ being connected to a measuring resistor $(R_m)$ in series with the deflector, their common connection point being connected via a capacitor $(T_{a1})$ to the base of the slaving transistor $(T_{a1})$ whose collector is connected to the input $(e_2)$ of the cyclic ration control circuit (3).

5. Circuit according to Claim 4, characterized in that the reference voltage of the static slaving circuit (6) is fixed by a resistor $(R_{a3})$ connected between the base of the slaving transistor $(T_{a1})$ and ground.

6. Frame scanning control circuit according to Claim 4 or 5, characterized in that the collector circuit of the slaving transistor $(T_{a1})$ includes a protection resistor $(R_{c1})$ for protection against excessive variations of the collector current of said slaving transistor.

7. Video frequency receiver comprising a frame scanning circuit in which: the energy necessary for generating the current in the vertical deflector $(D_v)$ is taken from the line flyback pulses by way of filter means and a single switch $(I_{S1})$ which comprises an active semiconductor element $(TH_1)$ having a control electrode, and a rectifier member $(D_{f1})$ connected in parallel and in reverse sense to the semiconductor element, the switch being controlled by a cyclic ratio control circuit (3) so that for each line scan period it becomes conductive during a time which is a function of the desired level for the current in the vertical deflector; a coupling capacitor $(C_L)$ is in a series with the vertical deflector and has a capacitance of sufficiently high value for the voltage at the terminals of the series assembly including the deflector and said capacitor to retain a constant sign; said cyclic ratio control circuit (3) is connected on the one hand to a static slaving circuit (6) permitting the stabilization of the mean value of the voltage at the terminals of the capacitor $(C_L)$ and, on the other hand, to a dynamic slaving circuit (7) for slaving the current in the deflector $(D_v)$ by the signal supplied by a corrected sawtooth frame signal generator (5); said cyclic ratio control circuit (3) includes a switching transistor $(T_{c1})$ receiving at its base on the one hand a sawtooth line synchronization signal and on the other hand the correction signals originating from the static (6) and dynamic (7) slaving circuits, its collector being connected to the control electrode of the switch $(I_{S1})$.

FIG_1

FIG_2

# FIG_3

(a) $V_{C1}$ vs $t$

(b) $V_{BE}$ vs $t$

(c) $V_C$ vs $t$, $t_c$, $t_h$